# FASCICULE DE BREVET EUROPEEN

(11) **EP 3 420 643 B1**
(45) Date de publication et mention de la délivrance du brevet: **14.10.2020**
(21) Numéro de dépôt: 17705158.8
(22) Date de dépôt: 20.02.2017
(51) Int. Cl.: H04B 3/02, H01P 3/02, H01P 5/12, H04B 3/52, H01P 5/16

(54) **CIRCUIT IMPRIMÉ EN TECHNOLOGIE UNIPLANAIRE**
MIT UNIPLANARER TECHNOLOGIE HERGESTELLTE LEITERPLATTE
PRINTED CIRCUIT PRODUCED WITH UNIPLANAR TECHNOLOGY

(30) Priorité: 23.02.2016 FR 1651450; 16.02.2017 FR 1751268
(43) Date de publication de la demande: 02.01.2019
(73) Titulaire: Safran Electronics & Defense, 92100 Boulogne-Billancourt (FR); Institut Polytechnique de Grenoble, 38000 Grenoble (FR)
(72) Inventeur: TIRARD, Franck, 92100 Boulogne Billancourt (FR); ANDRIAMIHARIVOLAMENA, Tsitoha, 92100 Boulogne Billancourt (FR); TEDJINI, Smail, 38000 Grenoble (FR); LEMAITRE-AUGER, Pierre, 38000 Grenoble (FR)
(74) Mandataire: Lavaud, Thomas
(86) Numéro de dépôt international: PCT/EP2017/053819
(87) Numéro de publication internationale: WO 2017/144424

(56) Documents cités:
- WO-A1-99/33166
- NAKATSUGAWA M ET AL: "A NOVEL CONFIGURATION FOR 1:N MULTIPORT POWER DIVIDERS USING SERIES/PARALLEL TRANSMISSION-LINE DIVISION AND A POLYIMIDE/ALUMINA-CERAMIC STRUCTURE FOR HPA MODULE IMPLEMENTATION", IEEE TRANSACTIONS ON MICROWAVE THEORY AND TECHNIQUES, IEEE SERVICE CENTER, PISCATAWAY, NJ, US, vol. 49, no. 6, PART 02, 1 juin 2001 (2001-06-01), pages 1187-1193, XP001093561, ISSN: 0018-9480, DOI: 10.1109/22.925519
- KISHIHARA M ET AL: "BROADBAND MULTI-WAY MICROSTRIP POWER DIVIDERS", IEICE TRANSACTIONS ON ELECTRONICS, INSTITUTE OF ELECTRONICS, TOKYO, JP, vol. E88-C, no. 1, 1 janvier 2005 (2005-01-01), pages 20-27, XP001221080, ISSN: 0916-8524, DOI: 10.1093/IETELE/E88-C.1.20

## Description

L'invention concerne le domaine des diviseurs de puissance radiofréquence ainsi que le domaine des vêtements intelligents intégrant des composants radiofréquences tels que des diviseurs de puissance.

### ARRIERE PLAN DE L'INVENTION

La réalisation de « vêtements intelligents » (ou de « textiles intelligents ») intégrant des composants électroniques pour mettre en œuvre des fonctions diverses (par exemple des fonctions de communication, de détection, de surveillance, d'alarme) est rendue possible notamment par les progrès effectués dans la conception des composants radiofréquences.

Les composants radiofréquences sont classiquement fabriqués sur des circuits imprimés dans lesquels des signaux radiofréquences se propagent sur des lignes de transmission microruban : on parle de topologie de circuit imprimé en microruban (ou MST pour « MicroSTrip »).

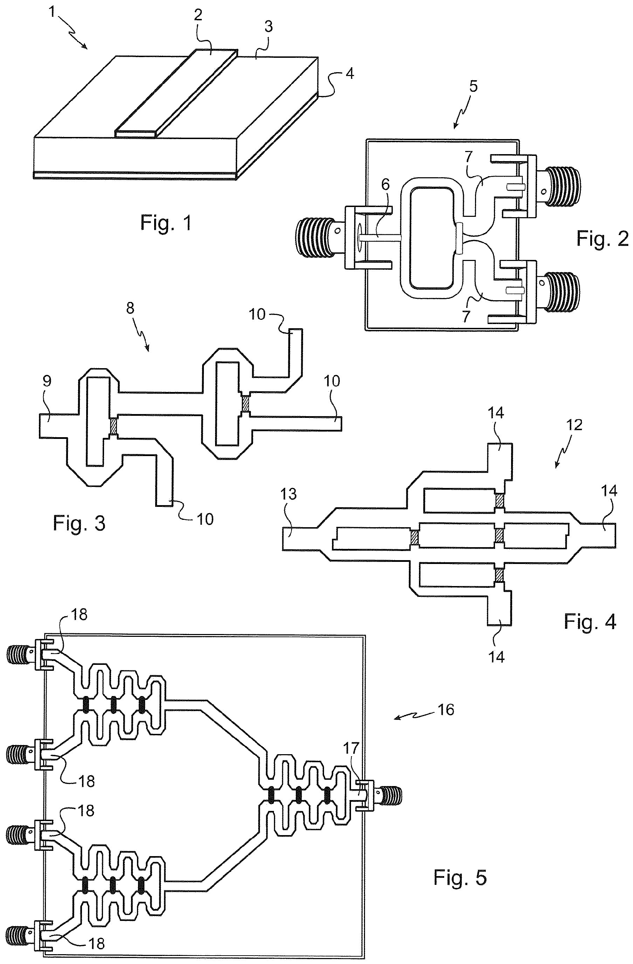

Une ligne de transmission microruban 1 est représentée sur la figure 1. La ligne de transmission microruban 1 comporte un ruban métallique 2, un substrat 3 et un plan de masse 4.

Lorsqu'il convient, dans un tel circuit imprimé, de connecter une pluralité d'antennes à une même source de puissance, on utilise un diviseur de puissance réalisé directement sur le circuit imprimé. Il existe plusieurs types de diviseurs de puissance adaptés à la topologie en microruban.

Un premier type de diviseur de puissance adapté à la topologie en microruban est un diviseur de Wilkinson.

Un circuit imprimé 5 constituant un diviseur de Wilkinson ayant une voie d'entrée 6 et deux voies de sortie 7 est visible sur la figure 2.

Un circuit imprimé 8 constituant un premier diviseur de Wilkinson ayant une voie d'entrée 9 et trois voies de sortie 10 est visible sur la figure 3.

Un circuit imprimé 12 constituant un deuxième diviseur de Wilkinson ayant une voie d'entrée 13 et trois voies de sortie 14 est visible sur la figure 4.

Un circuit imprimé 16 constituant un diviseur de Wilkinson ayant une voie d'entrée 17 et quatre voies de sortie 18 est visible sur la figure 5.

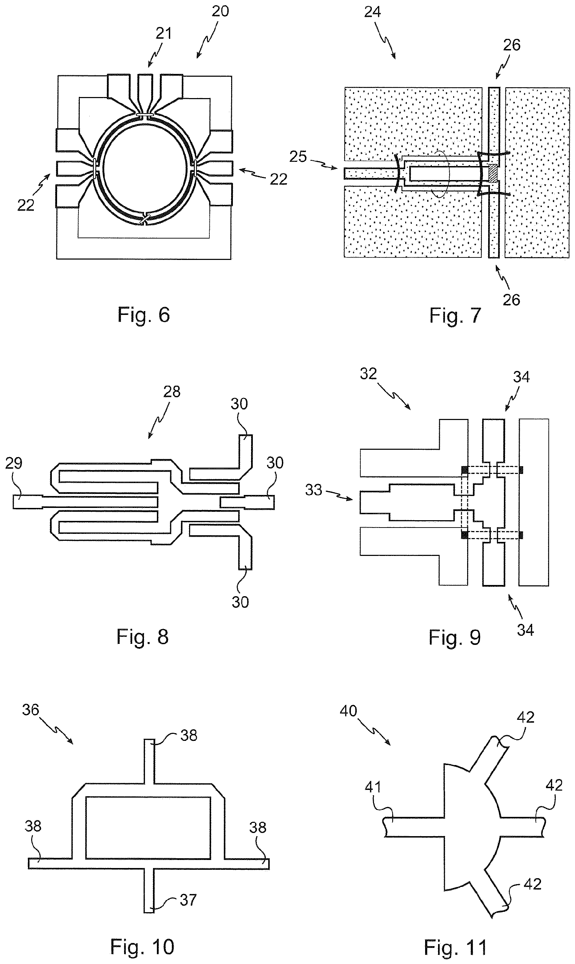

Un deuxième type de diviseur de puissance adapté à la topologie en microruban est un diviseur de Wilkinson en anneau. Un circuit imprimé 20 constituant un diviseur de Wilkinson en anneau ayant une voie d'entrée 21 et deux voies de sortie 22 est visible sur la figure 6.

Un troisième type de diviseur de puissance adapté à la topologie en microruban est un diviseur basé sur des lignes couplées. Un circuit imprimé 24 constituant un diviseur basé sur des lignes couplées ayant une voie d'entrée 25 et deux voies de sortie 26 est visible sur la figure 7.

Un quatrième type de diviseur de puissance adapté à la topologie en microruban est un diviseur à « jonction en T ». Un circuit imprimé 28 constituant un diviseur à jonction en T ayant une voie d'entrée 29 et trois voies de sortie 30 est visible sur la figure 8.

Un cinquième type de diviseur de puissance adapté à la topologie en microruban est un diviseur basé sur des résonateurs. Un circuit imprimé 32 constituant un diviseur basé sur des résonateurs ayant une voie d'entrée 33 et deux voies de sortie 34 est visible sur la figure 9.

Un sixième type de diviseur de puissance adapté à la topologie en microruban est un diviseur de Bagley. Un circuit imprimé 36 constituant un diviseur de Bagley ayant une voie d'entrée 37 et trois voies de sortie 38 est visible sur la figure 10.

Un septième type de diviseur de puissance adapté à la topologie en microruban est un diviseur en forme de secteur circulaire. Un circuit imprimé 40 constituant un diviseur en forme de secteur circulaire ayant une voie d'entrée 41 et trois voies de sortie 42 est visible sur la figure 11. Autres exemples de diviseurs de puissance en microruban sont divulgués dans la demande PCT WO 99/33166, ainsi que dans Nakatsugawa M. et al, "A novel configuration for 1:N multiport power dividers using series/parallel transmission-line division and a polyimide/aluminaceramic structure for HPA module implémentation", IEEE TRANSACTIONS ON MICROWAVE THEORY AND TECHNIQUES, vol. 49, n. 6, part 02, pages 1187-1193, et dans KISHIHARA M ET AL: "BROADBAND MULTI-WAY MICROSTRIP POWER DIVIDERS", IEICE TRANSACTIONS ON ELECTRONICS, vol. E88-C, no. 1, pages 20-27.

Ainsi, il existe un choix important de diviseurs de puissance adaptés à la topologie de circuit imprimé en microruban.

Chacun de ces diviseurs de puissance, mis en œuvre dans un circuit imprimé en microruban, présente des particularités techniques électriques ou électromagnétiques qui permettent de sélectionner le diviseur de puissance le plus approprié pour une application particulière. Par exemple, le diviseur de Wilkinson et le diviseur de Wilkinson en anneau présentent une bonne isolation entre les voies de sortie grâce à l'utilisation d'une résistance d'isolation. Par exemple encore, le diviseur basé sur des résonateurs présente une bande passante très étroite.

Cependant, aucun de ces diviseurs de puissance mis en œuvre dans un circuit imprimé en microruban ne constitue une solution particulièrement avantageuse pour une utilisation dans un vêtement intelligent. En particulier, un circuit imprimé en microruban sur lequel est constitué un diviseur de puissance radiofréquence ayant une voie d'entrée et trois voies de sortie est relativement encombrant et complexe à intégrer sur un vêtement intelligent.

### OBJET DE L'INVENTION

L'objet de l'invention est de simplifier l'intégration d'un diviseur de puissance radiofréquence dans un vêtement intelligent.

### RESUME DE L'INVENTION

En vue de la réalisation de ce but, on propose un circuit imprimé en technologie uniplanaire comportant des lignes de transmission imprimées sur un substrat diélectrique, le circuit imprimé constituant un diviseur de puissance radiofréquence comprenant un unique bloc diviseur ayant une voie d'entrée et trois voies de sortie.

Le circuit imprimé de l'invention est particulièrement adapté à une intégration dans un vêtement intelligent, car l'impression (ou métallisation) du circuit imprimé est réalisée sur une seule face du substrat diélectrique du circuit imprimé. Le circuit imprimé de l'invention peut ainsi être imprimé sur une surface textile du vêtement intelligent grâce à une technologie d'impression à faible coût, telle que l'impression par jet d'encre ou la sérigraphie.

De plus, la mise en œuvre du diviseur de puissance radiofréquence en un seul bloc permet de réduire l'encombrement du circuit imprimé, ce qui, une fois encore, facilite l'intégration du circuit imprimé dans le vêtement intelligent.

D'autres caractéristiques et avantages de l'invention ressortiront à la lecture de la description qui suit de modes de réalisation particuliers, non limitatifs de l'invention.

### BREVE DESCRIPTION DES DESSINS

Il sera fait référence aux dessins annexés parmi lesquels :
- la figure 1 représente une ligne de transmission microruban de l'art antérieur ;
- la figure 2 représente un diviseur de puissance de Wilkinson ayant une voie d'entrée et deux voies de sortie de l'art antérieur ;
- la figure 3 représente un premier diviseur de puissance de Wilkinson ayant une voie d'entrée et trois voies de sortie de l'art antérieur ;
- la figure 4 représente un deuxième diviseur de puissance de Wilkinson ayant une voie d'entrée et trois voies de sortie de l'art antérieur ;
- la figure 5 représente un diviseur de puissance de Wilkinson ayant une voie d'entrée et quatre voies de sortie de l'art antérieur ;
- la figure 6 représente un diviseur de puissance de Wilkinson en anneau ayant une voie d'entrée et deux voies de sortie de l'art antérieur ;
- la figure 7 représente un diviseur de puissance basé sur des lignes couplées ayant une voie d'entrée et deux voies de sortie de l'art antérieur ;
- la figure 8 représente un diviseur de puissance à jonction « en T » ayant une voie d'entrée et trois voies de sortie de l'art antérieur ;
- la figure 9 représente un diviseur de puissance basé sur des résonateurs ayant une voie d'entrée et deux voies de sortie de l'art antérieur ;
- la figure 10 représente un diviseur de puissance de Bagley ayant une voie d'entrée et trois voies de sortie de l'art antérieur;
- la figure 11 représente un diviseur de puissance en forme de secteur circulaire ayant une voie d'entrée et trois voies de sortie de l'art antérieur ;
- la figure 12 représente une face imprimée d'un circuit imprimé selon un premier mode de réalisation de l'invention ;
- la figure 13 est une vue en section du circuit imprimé selon le premier mode de réalisation de l'invention au niveau d'une portion interne d'une voie de sortie d'un diviseur de puissance radiofréquence du circuit imprimé selon le premier mode de réalisation de l'invention ;
- la figure 14 est une vue en section du circuit imprimé selon le premier mode de réalisation de l'invention au niveau d'une portion externe d'une voie de sortie du diviseur de puissance radiofréquence ;
- la figure 15 est un graphique sur lequel est représentée une courbe d'un coefficient de réflexion du diviseur de puissance radiofréquence du circuit imprimé selon le premier mode de réalisation de l'invention ;
- la figure 16 est un graphique sur lequel sont représentées des courbes de coefficient de transmission du diviseur de puissance radiofréquence du circuit imprimé selon le premier mode de réalisation de l'invention ;
- la figure 17 est un graphique sur lequel est représentée une courbe d'une perte d'insertion du diviseur de puissance radiofréquence du circuit imprimé selon le premier mode de réalisation de l'invention ;
- la figure 18 est un graphique sur lequel sont représentées des courbes de déséquilibre d'amplitude en sortie du diviseur de puissance radiofréquence du circuit imprimé selon le premier mode de réalisation de l'invention ;
- la figure 19 représente une face imprimée d'un circuit imprimée selon un deuxième mode de réalisation de l'invention ;
- la figure 20 est une vue en section du circuit imprimé selon le deuxième mode de réalisation de l'invention au niveau d'une portion interne d'une voie de sortie d'un diviseur de puissance radiofréquence du circuit imprimé selon le deuxième mode de réalisation de l'invention;
- la figure 21 est une vue en section du circuit imprimé selon le deuxième mode de réalisation de l'invention au niveau d'une portion externe d'une voie de sortie du diviseur de puissance radiofréquence ;
- la figure 22 est un graphique sur lequel sont représentées des courbes de coefficient de réflexion du diviseur de puissance radiofréquence du circuit imprimé selon le deuxième mode de réalisation de l'invention ;
- la figure 23 est un graphique sur lequel sont représentées des courbes de coefficient de transmission du diviseur de puissance radiofréquence du circuit imprimé selon le deuxième mode de réalisation de l'invention ;
- la figure 24 est un graphique sur lequel sont représentées des courbes d'une perte d'insertion du diviseur de puissance radiofréquence du circuit imprimé selon le deuxième mode de réalisation de l'invention ;
- la figure 25 est un graphique sur lequel sont représentées des courbes de déséquilibre d'amplitude en sortie du diviseur de puissance radiofréquence du circuit imprimé selon le deuxième mode de réalisation de l'invention.

### DESCRIPTION DETAILLEE DE L'INVENTION

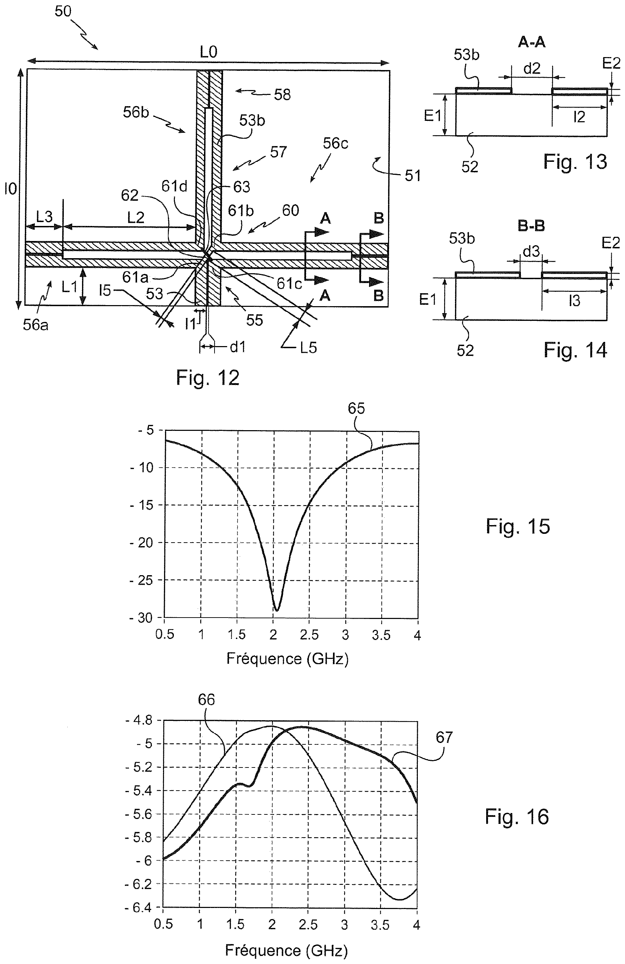

En référence aux figures 12 à 14, un circuit imprimé selon un premier mode de réalisation de l'invention 50 est ici un circuit imprimé de forme rectangulaire et sensiblement plate. Par sensiblement plate, on entend que l'épaisseur du circuit imprimé selon le premier mode de réalisation de l'invention 50 est très faible par rapport à la largeur 10 et à la longueur L0 des faces du circuit imprimé selon le premier mode de réalisation de l'invention 50.

Le circuit imprimé 50 est en technologie uniplanaire, c'est à dire qu'il est imprimé au niveau d'un seul plan dans une seule couche du circuit imprimé 50, ladite couche étant elle-même positionnée sur l'une des deux faces du circuit imprimé 50 dite « face imprimée » 51.

Le circuit imprimé 50 comporte un substrat diélectrique 52 et une pluralité de rubans métalliques minces 53 qui s'étendent sur la face imprimée 51 et qui sont déposés sur le substrat diélectrique 52.

Le circuit imprimé 50 ne comporte pas de couche métallisée formant un plan de masse.

L'épaisseur E1 du substrat diélectrique 52 est de 150 µm. Le substrat diélectrique 52 est ici en Kapton (εᵣ = 3,4 ; tan δ = 0,005).

Les rubans métalliques 53 sont ici en cuivre et présentent une épaisseur E2 = 18 µm.

Les rubans métalliques 53 imprimés sur le substrat diélectrique 52 forment des lignes de transmission qui présentent une topologie en ruban coplanaire (ou topologie CPS, pour « CoPlanar Strip »). Chaque ligne de transmission comporte deux rubans métalliques 53.

Le circuit imprimé 50 constitue un diviseur de puissance radiofréquence ayant une voie d'entrée 55 et une première voie de sortie 56a, une deuxième voie de sortie 56b et une troisième voie de sortie 56c, lesdites voie d'entrée 55 et voies de sortie 56 étant constituées par les lignes de transmission. Le diviseur de puissance radiofréquence et le circuit imprimé 50 ont été conçus et optimisés avec un outil logiciel de simulation pour fonctionner dans la bande de fréquence ISM centrée sur 2,45 GHz (ISM pour « industriel, scientifique et médical »).

La voie d'entrée 55 du diviseur de puissance radiofréquence est destinée à être connectée à une source de puissance, alors que chaque voie de sortie 56 du diviseur de puissance radiofréquence est destinée à être connectée à une antenne radiofréquence distincte.

La voie d'entrée 55 s'étend depuis le milieu de l'un des grands côtés de la face imprimée 51 perpendiculairement à ce grand côté. La première voie de sortie 56a s'étend depuis l'un des petits côtés de la face imprimée 51 perpendiculairement à ce petit côté. La deuxième voie de sortie 56b s'étend depuis le milieu de l'autre grand côté de la face imprimée 51 perpendiculairement à cet autre grand côté, de sorte que la voie d'entrée 55 et la deuxième voie de sortie 56b sont alignées. La troisième voie de sortie 56c s'étend depuis l'autre petit côté de la face imprimée 51 perpendiculairement à cet autre petit côté, de sorte que la première voie de sortie 56a et la troisième voie de sortie 56c sont alignées.

La voie d'entrée 55 est constituée de deux premiers rubans métalliques 53a de longueur L1, de largeur l1, espacés d'une distance d1.

Chaque voie de sortie 56 est formée par deux deuxièmes rubans métalliques 53b. Chaque voie de sortie 56 comprend une portion interne 57 qui s'étend vers l'intérieur de la face imprimée 51 et une portion externe 58 qui s'étend jusqu'à un côté de la face imprimée 51.

Chaque portion interne 57 de chaque voie de sortie 56 présente une longueur L2 = 31,83 mm. Chaque portion externe 58 de chaque voie de sortie 56 présente une longueur L3.

Les deux deuxièmes rubans métalliques 53b de chaque voie de sortie 56 présentent une largeur l2 = 0,9 mm sur la portion interne 57, puis s'élargissent et présentent une largeur l3 = 1,25 mm sur la portion externe 58. Sur la portion interne 57, les deuxièmes rubans métalliques 53b sont espacés d'une distance d2 = 0,85 mm. Sur la portion externe 58, les deuxièmes rubans métalliques 53b sont espacés d'une distance d3 = 0,15 mm.

La longueur L1 de chaque premier ruban métallique 53a est sensiblement égale à la longueur L3 de la portion externe 58.

La largeur l1 de chaque premier ruban métallique 53a est sensiblement égale à la largeur l3 de chaque deuxième ruban métallique 53b sur la portion externe 58.

La distance d1 entre les deux premiers rubans métalliques 53a de la voie d'entrée 55 est sensiblement égale à la distance d3 entre les deuxièmes rubans métalliques 53b sur la portion externe 58 de chaque voie de sortie 56.

La portion interne 57 de chaque voie de sortie 56 présente une impédance Z1 = 208 Ω. La portion externe 58 de chaque voie de sortie 56 présente une impédance Z2 = 120 Ω.

La voie d'entrée 55 et les trois voies de sortie 56 se rejoignent pour définir un premier croisement 60 présentant quatre coins internes 61 : un premier coin interne 61a formé par un premier ruban 53a et un deuxième ruban 53b de la première voie de sortie 56a, un deuxième coin interne 61b formé par un deuxième ruban 53b de la deuxième voie de sortie 56b et un deuxième ruban 53b de la troisième voie de sortie 56c, un troisième coin interne 61c formé par l'autre premier ruban 53a et l'autre deuxième ruban 53b de la troisième voie de sortie 56a, et un quatrième coin interne 61d formé par l'autre deuxième ruban 53b de la première voie de sortie 56a et l'autre deuxième ruban 53b de la deuxième voie de sortie 56b.

Un raccord imprimé 62 relie le premier coin interne 61a et le deuxième coin interne 61b. Le raccord imprimé 62 a une longueur L5 = 1,01 mm et une largeur l5 = 0,25 mm.

Un pont à air 63 relie le troisième coin interne 61c et le quatrième coin interne 61d.

Les courbes des figures 15 à 18 montrent les performances du diviseur de puissance radiofréquence du circuit imprimé 50.

Un coefficient de réflexion 65 du diviseur de puissance radiofréquence du circuit imprimé 50 est représenté sur la figure 15. On voit sur la figure 15 que le diviseur de puissance radiofréquence du circuit imprimé 50 présente une bonne adaptation (-29 dB) à sa fréquence de résonance (2,05 GHz). Il a une bande passante à -10 dB de [1,25 - 2,9] GHz, soit 80% à 2,05 GHz. La bande passante couvre la bande ISM à 2,45 GHz.

Sur la figure 16, un premier coefficient de transmission 66 correspond au coefficient de transmission entre la voie d'entrée 55 et la première voie de sortie 56a, et un deuxième coefficient de transmission 67 correspond au coefficient de transmission entre la voie d'entrée 55 et la deuxième voie de sortie 56b. Seuls le premier coefficient de transmission 66 et le deuxième coefficient de transmission 67 sont représentés car la première voie de sortie 56a et la troisième voie de sortie 56c sont symétriques par rapport à la voie d'entrée 55.

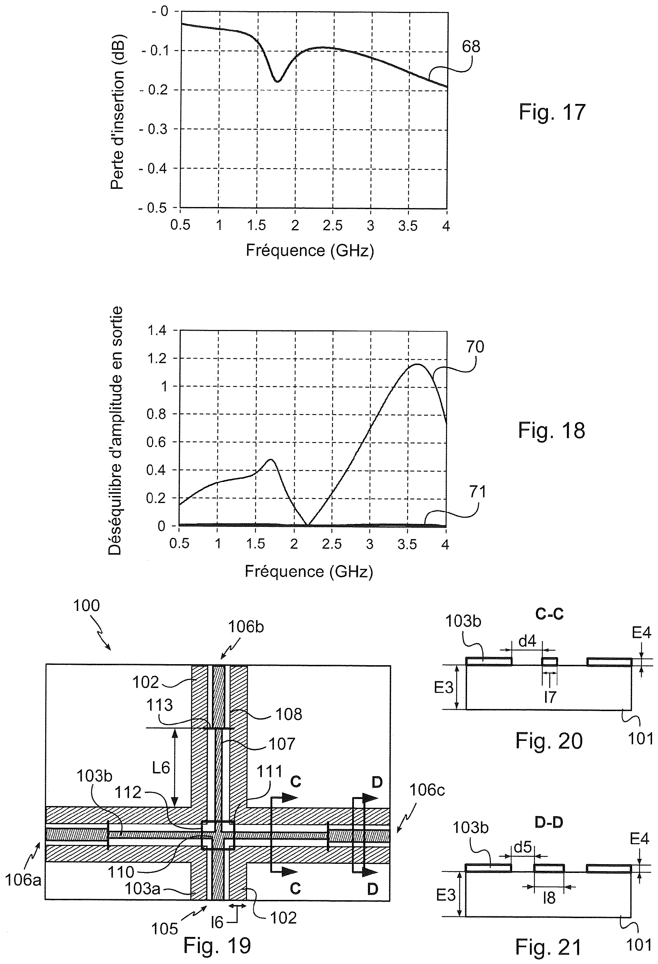

Une perte d'insertion 68 du diviseur de puissance radiofréquence du circuit imprimé 50 est représentée sur la figure 17. On note que la perte d'insertion est inférieure à 0,2 dB sur toute la bande passante.

Une courbe d'un premier déséquilibre d'amplitude 70 entre la première voie de sortie 56a et la deuxième voie de sortie 56b et une courbe d'un deuxième déséquilibre d'amplitude 71 entre la première voie de sortie 56a et la troisième voie de sortie 56c sont représentées sur la figure 18. On note que les voies de sortie 56 sont équilibrées sur toute la bande passante : la variation maximale d'amplitude est inférieure à 0,7 dB sur toute la bande passante.

En référence aux figures 19 à 21, un circuit imprimé selon un deuxième mode de réalisation de l'invention 100 est à nouveau réalisé en technologie uniplanaire.

Le circuit imprimé 100 comporte un substrat diélectrique 101 et une pluralité de rubans métalliques minces qui sont déposés sur le substrat diélectrique 101.

L'épaisseur E3 du substrat diélectrique 101 est de 0,8 mm. Le substrat diélectrique 101 est ici en FR4 (εᵣ = 4,5 ; tan δ = 0,025).

Les rubans métalliques sont ici en cuivre et présentent une épaisseur E4 = 17 µm.

Les rubans métalliques imprimés sur le substrat diélectrique 101 forment des lignes de transmission qui présentent une topologie en guide d'onde coplanaire (ou topologie CPW, pour « CoPlanar Waveguide »). Chaque ligne de transmission comporte deux rubans métalliques de masse 102 et un ruban métallique central 103.

Le circuit imprimé 100 constitue un diviseur de puissance radiofréquence ayant une voie d'entrée 105 et une première voie de sortie 106a, une deuxième voie de sortie 106b et une troisième voie de sortie 106c, lesdites voie d'entrée 105 et voies de sortie 106 étant constituées par les lignes de transmission. Le diviseur de puissance radiofréquence et le circuit imprimé 100 ont été conçus et optimisés pour fonctionner dans la bande de fréquence ISM centrée sur 2,45 GHz.

A nouveau, la voie d'entrée 105 s'étend depuis le milieu de l'un des grands côtés de la face imprimée du circuit imprimé 100 perpendiculairement à ce grand côté. La première voie de sortie 106a s'étend depuis l'un des petits côtés de la face imprimée perpendiculairement à ce petit côté. La deuxième voie de sortie 106b s'étend depuis le milieu de l'autre grand côté de la face imprimée perpendiculairement à cet autre grand côté, de sorte que la voie d'entrée 105 et la deuxième voie de sortie 106b sont alignées. La troisième voie de sortie 106c s'étend depuis l'autre petit côté de la face imprimée perpendiculairement à cet autre petit côté, de sorte que la première voie de sortie 106a et la troisième voie de sortie 106c sont alignées.

La voie d'entrée 105 est constituée de deux rubans métalliques de masse 102 de largeur l6 = 5mm et d'un premier ruban métallique central 103a de largeur constante.

Chaque voie de sortie 106 est constituée de deux rubans métalliques de masse 102 (de même largeur 16 que les rubans métalliques de masse 102 de la voie d'entrée 105) et d'un deuxième ruban métallique central 103b.

Chaque voie de sortie 106 comprend une portion interne 107 qui s'étend vers l'intérieur de la face imprimée et une portion externe 108 qui s'étend jusqu'à un côté de la face imprimée.

Chaque portion interne 107 de chaque voie de sortie 106 présente une longueur L6 = 24,73 mm.

Le deuxième ruban métallique central 103b de chaque voie de sortie 106 présente une largeur 17 = 1,5 mm sur la portion interne 107, puis s'élargit et présente une largeur l8 = 2,84 mm sur la portion externe 108. Sur la portion interne 107, le deuxième ruban métallique central 103b est espacé de chaque ruban métallique de masse 102 d'une distance d4 = 0,94 mm. Sur la portion externe 108, le deuxième ruban métallique central 103b est espacé de chaque ruban métallique de masse 102 d'une distance d5 = 0,27 mm.

La portion interne 107 de chaque voie de sortie 106 présente une impédance Z3 = 87 Ω. La portion externe 108 de chaque voie de sortie 106 présente une impédance Z4 = 50 Ω.

La voie d'entrée 105 et les trois voies de sortie 106 se rejoignent pour définir un deuxième croisement 110 présentant quatre coins internes 111.

Quatre ponts à air 112 relient entre eux les quatre coins internes 111 de manière à former un carré dont les côtés sont les ponts à air 112 et les coins sont les coins internes 111. Bien sûr, le « carré » pourrait parfaitement être un rectangle.

De plus, chaque voie de sortie 106 comprend un pont à air 113 qui relie les rubans métalliques de masse 102 de chaque voie de sortie 106 à l'endroit où s'élargit le deuxième ruban métallique central 103b de la voie de sortie 106 (c'est-à-dire à l'endroit où se rejoignent la portion interne 107 et la portion externe 108).

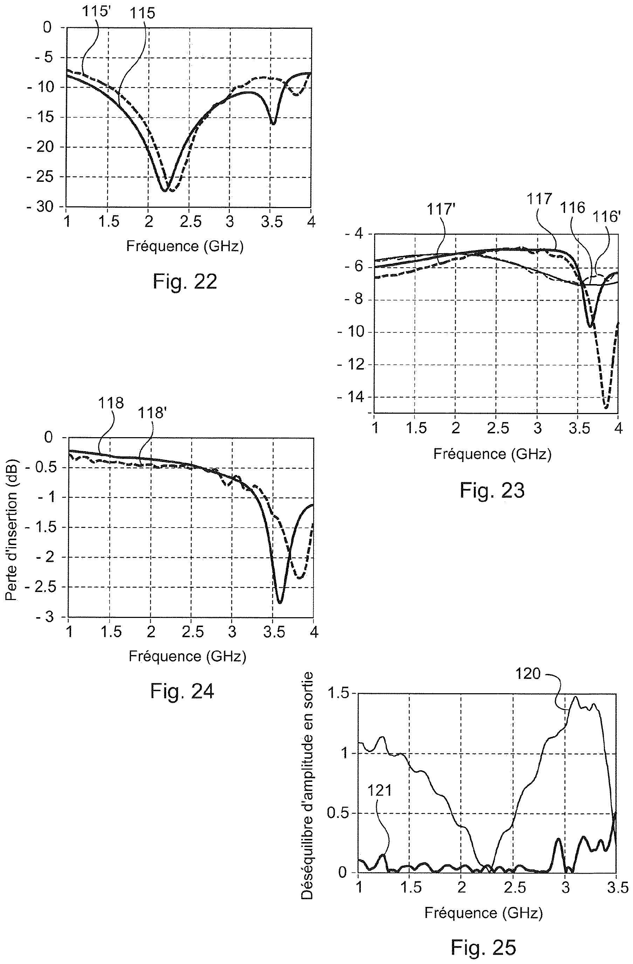

Les courbes des figures 22 à 25 montrent les performances du diviseur de puissance radiofréquence du circuit imprimé 100.

Un coefficient de réflexion simulé 115 et un coefficient de réflexion mesuré 115' du diviseur de puissance radiofréquence du circuit imprimé 100 sont représentés sur la figure 22. On voit sur la figure 15 que le diviseur de puissance radiofréquence du circuit imprimé 100 présente une bonne adaptation (-28 dB) à sa fréquence de résonance (2,3 GHz). Il a une bande passante à -10 dB de [1,52 - 3,1] GHz, soit 70%. La bande passante couvre la bande ISM à 2,45 GHz.

Sur la figure 23, un premier coefficient de transmission simulé 116 et un premier coefficient de transmission mesuré 116' correspondent au coefficient de transmission entre la voie d'entrée 105 et la première voie de sortie 106a, et un deuxième coefficient de transmission simulé 117 et un deuxième coefficient de transmission mesuré 117' correspondent au coefficient de transmission entre la voie d'entrée 105 et la deuxième voie de sortie 106b.

Une perte d'insertion simulée 118 et une perte d'insertion mesurée 118' du diviseur de puissance radiofréquence du circuit imprimé 100 sont représentées sur la figure 24. On note que la perte d'insertion, principalement due à la perte dans le substrat diélectrique 101, est inférieure à 1 dB sur toute la bande passante.

Une courbe d'un premier déséquilibre d'amplitude 120 entre la première voie de sortie 106a et la deuxième voie de sortie 106b et une courbe d'un deuxième déséquilibre d'amplitude 121 entre la première voie de sortie 106a et la troisième voie de sortie 106c sont représentées sur la figure 25. On note que les voies de sortie 106 sont équilibrées sur toute la bande passante : la variation maximale d'amplitude est inférieure à 1,5 dB sur toute la bande passante.

On note que le diviseur de puissance radiofréquence du circuit imprimé selon le premier mode de réalisation de l'invention 50 et le diviseur de puissance radiofréquence du circuit imprimé selon le deuxième mode de réalisation de l'invention 100 comportent chacun un unique bloc diviseur comprenant une voie d'entrée et trois voies de sortie, contrairement aux diviseurs des figures 3, 4, 5, 8, 10 qui comportent une pluralité de blocs diviseurs. L'encombrement des circuits imprimés 50, 100 est donc réduit.

On note aussi que les circuits imprimés 50, 100 et les substrats associés sont assez souples pour pouvoir être incorporés à un vêtement sans excessivement raidir celui-ci. De plus, comme l'impression (ou métallisation) de ces circuits imprimés est réalisée sur une seule face du substrat diélectrique des circuits imprimés, les circuits imprimés 50 et 100 sont particulièrement adaptés à une intégration dans un vêtement intelligent (ou textile intelligent). Les circuits imprimés de l'invention peuvent ainsi être imprimés sur une surface de textile du vêtement intelligent grâce à une technologie d'impression à faible coût, telle que l'impression par jet d'encre ou la sérigraphie.

L'invention n'est pas limitée aux modes de réalisation particuliers qui viennent d'être décrits, mais, bien au contraire, couvre toute variante entrant dans le cadre de l'invention telle que définie par les revendications.

## Revendications

1. Circuit imprimé en technologie uniplanaire comportant des lignes de transmission appartenant à une face imprimée et imprimées sur un substrat diélectrique (52 ; 101), le circuit imprimé constituant un diviseur de puissance radiofréquence comprenant un unique bloc diviseur ayant une voie d'entrée (55 ; 105) et trois voies de sortie (56 ; 106), les lignes de transmission présentant une topologie en guide d'onde coplanaire, la voie d'entrée (105) comportant deux rubans métalliques de masse (102) et un premier ruban métallique central (103a) de largeur constante, ledit circuit imprimé **caractérisé en ce que** chaque voie de sortie (106) comporte deux rubans métalliques de masse (102) et un deuxième ruban métallique central (103b) qui s'élargit sur une portion externe (108) de la voie de sortie.

2. Circuit imprimé selon la revendication 1, dans lequel chaque voie de sortie (106) comprend un pont à air 113 ) qui relie les rubans métalliques de masse de la voie de sortie à l'endroit où s'élargit le deuxième ruban métallique central de la voie de sortie.

3. Circuit imprimé selon la revendication 1, dans lequel la voie d'entrée et les trois voies de sortie se rejoignent pour définir un deuxième croisement (110) présentant quatre coins internes (111) reliés entre eux par quatre ponts à air (112).

4. Circuit imprimé selon la revendication 1, dans lequel le substrat diélectrique (101) du circuit imprimé est en FR4.

5. Système radiofréquence comportant un circuit imprimé (50 ; 100) selon l'une des revendications précédentes et trois antennes radiofréquences connectées chacune une voie de sortie distincte.

6. Vêtement comportant une surface de textile sur laquelle est imprimé un circuit imprimé selon l'une des revendications précédentes.

7. Vêtement selon la revendication 6, dans lequel l'impression du circuit imprimé est réalisée par jet d'encre ou par sérigraphie.

## Patentansprüche

1. Leiterplatte in uniplanarer Technologie, umfassend Übertragungsleitungen, die zu einer bedruckten Fläche gehören und auf ein dielektrisches Substrat (52; 101) gedruckt sind, wobei die Leiterplatte einen Funkfrequenz-Leistungsteiler bildet, der einen einzigen Teilerblock umfasst, der einen Eingangspfad (55; 105) und drei Ausgangspfade (56; 106) hat, wobei die Übertragungsleitungen eine Topologie mit koplanarem Wellenleiter aufweisen, wobei der Eingangspfad (105) zwei metallene Massebänder (102) und ein erstes zentrales metallenes Band (103a) mit konstanter Breite umfasst, wobei die Leiterplatte **dadurch gekennzeichnet ist, dass** jeder Ausgangspfad (106) zwei metallene Massebänder (102) und ein zweites zentrales metallenes Band (103b) umfasst, das sich auf einem äußeren Abschnitt (108) des Ausgangspfades verbreitert.

2. Leiterplatte nach Anspruch 1, bei der jeder Ausgangspfad (106) eine Luftbrücke (113) umfasst, die die metallenen Massebänder des Ausgangspfades an der Stelle verbindet, an der sich das zweite zentrale metallene Band des Ausgangspfades verbreitert.

3. Leiterplatte nach Anspruch 1, bei der der Eingangspfad und die drei Ausgangspfade zusammenlaufen, um eine zweite Kreuzung (110) zu definieren, die vier Innenecken (111) aufweist, die miteinander über vier Luftbrücken (112) verbunden sind.

4. Leiterplatte nach Anspruch 1, bei der das dielektrische Substrat (101) der Leiterplatte aus FR4 ist.

5. Funkfrequenzsystem, umfassend eine Leiterplatte (50; 100) nach einem der vorhergehenden Ansprüche und drei Funkfrequenzantennen, die jeweils mit einem anderen Ausgangspfad verbunden sind.

6. Kleidungsstück, umfassend eine Textiloberfläche, auf der eine Leiterplatte nach einem der vorhergehenden Ansprüche aufgedruckt ist.

7. Kleidungsstück nach Anspruch 6, bei dem der Aufdruck der Leiterplatte mittels Tintenstrahl oder Siebdruck erfolgt.

## Claims

1. Printed circuit produced with uniplanar technology, comprising transmission lines belonging to a printed surface and printed on a dielectric substrate (52; 101), the printed circuit constituting a radiofrequency power divider comprising a single divider block having an input channel (55; 105) and three output channels (56; 106), the transmission lines having the topology of a coplanar waveguide, the input channel (105) comprising two metal earthing strips (102) and a first central metal strip (103a) of a constant width, said printed circuit being **characterised in that** each output channel (106) comprises two metal earthing strips (102) and a second central metal strip (103b) that widens over an outer portion (108) of the output channel.

2. Printed circuit according to claim 1, wherein each output channel (106) comprises an air bridge (113) that connects the metal earthing strips of the output channel to the point where the second central metal strip of the output channel widens.

3. Printed circuit according to claim 1, wherein the input channel and the three output channels join so as to define a second crossover point (110) having four inner corners (111) interconnected by four air bridges (112).

4. Printed circuit according to claim 1, wherein the dielectric substrate (101) of the printed circuit consists of FR4.

5. Radiofrequency system comprising a printed circuit (50; 100) according to any of the preceding claims and three radiofrequency antennae each connected a separate output channel.

6. Item of clothing comprising a textile surface on which a printed circuit according to any of the preceding claims is printed.

7. Item of clothing according to claim 6, wherein the printed circuit is printed using an inkjet or by means of screen printing.
